# EUROPÄISCHE PATENTSCHRIFT

(11) **EP 1 185 155 B1**
(45) Veröffentlichungstag und Bekanntmachung des Hinweises auf die Patenterteilung: **05.04.2006**
(21) Anmeldenummer: 00118835.8
(22) Anmeldetag: 31.08.2000
(51) Int. Cl.: H05K 9/00

(54) **Vorrichtung zum Abschirmen von elektrotechnischen Bauelementen**
Electromagnetical shielding of electrotechnical components
Blindage électromagnétique de composants de l'électrotechnique

(43) Veröffentlichungstag der Anmeldung: 06.03.2002
(73) Patentinhaber: Siemens Schweiz AG, 8047 Zürich (CH)
(72) Erfinder: Reupke, Alfred, 8304 Wallisellen (CH)
(74) Vertreter: Berg, Peter

(56) Entgegenhaltungen:
- EP-A- 0 886 464
- US-A- 5 886 879

## Beschreibung

Die Erfindung bezieht sich auf eine Vorrichtung zum Abschirmen von elektrotechnischen Bauelementen mit einem Rahmen und mit mindestens einem Deckel, der auf dem Rahmen festsetzbar ist.

In einer Vielzahl von elektrotechnischen Anwendungen ist es erforderlich, die eingesetzten elektrotechnischen Bauelemente, wie Speicherchips, Mikroprozessoren und dergleichen, gegen elektrische und/oder magnetische Felder und/oder die von ihnen ausgehenden elektrischen und/oder magnetischen Felder abzuschirmen. Beispielhaft als Anwendung seien die mit derartigen Bauelementen bestückten Leiterplatten in einem Computer, in einem mobilen Telefon und in einem kabellosen Netzzugangsgerät (Wireless LAN) genannt.

In Abhängigkeit von den abzuschirmenden Feldern und den eingesetzten EMV-sensiblen Bauelementen kann es vorgesehen sein, dass das gesamte Gerät oder auch nur einzelne Bauelemente auf einer Leiterplatte von einer Abschirmkammer umgeben sind. Bei der letztgenannten Variante wird die Befestigung der Abschirmkammer in den meisten Fällen durch Löten vorgenommen. Dabei wird die Abschirmkammer oft zusammen mit den Bauelementen aufgelötet, und zwar je nach den verwendeten Bauelementen nach SMT- oder THT-Methode (Surface-Mount-Technology oder Through-Hole-Technology).

Stellt sich nun jedoch bei der Kontrolle einer Leiterplatine heraus, dass ein Bauelement innerhalb der Abschirmkammer defekt ist und ausgetauscht werden muss, muss die Abschirmkammer wieder geöffnet werden.

Sofern die Abschirmkammer keinen Deckel aufweist, muss sie wieder abgelötet werden, was bei den üblicherweise zahlreichen Lötpunkten zur Leiterplatte sehr aufwendig oder gar unmöglich ist. Aus diesem Grund sind die Abschirmkammern in der Regel so ausgestaltet, dass sie einen Grundrahmen besitzen und über einen auf diesen Grundrahmen aufsetzbaren Deckel verfügen. Wenn bei einem Gerät mechanische Umweltbelastungen (Stoss, Vibration, Schock) eher gering sind, wird der Deckel meist nur mittels Federzungen auf dem Grundrahmen angeklammert. Sind hingegen die mechanischen Belastungen grösser, wird der Deckel formschlüssig gesichert. Denkbar sind hierbei die Sicherung durch das Umbiegen von Laschen, das Schrauben oder Löten, das Niederhalten durch entsprechende Zapfen, Rippen oder dergleichen.

Der Nachteil aller vorstehend genannten Varianten von Abschirmkammern besteht jedoch darin, dass die Grundrahmen und die Deckel vielfach etliche Blechbiegeschritte bei deren Herstellung durchlaufen müssen und zudem mit vergleichsweise engen Fertigungstoleranzen gefertigt werden müssen. Dies führt dazu, dass derartig aufgebaute Abschirmkammern in der Fertigung und auch hinsichtlich der dort verwendeten Werkzeuge und Verfahrensschritte vergleichsweise teuer sind.

Aus der US-A-5 886 879 ist eine Abschirmkammer mit einem Deckel, der entfernbar gehalten wird, bekannt.

Der vorliegenden Erfindung liegt daher die Aufgabe zugrunde, eine Vorrichtung zum Abschirmen elektrotechnischer Bauelemente anzugeben, die in der Herstellung preiswert, leicht zu montieren und einfach wieder zu öffnen und zu verschliessen ist.

Diese Aufgabe wird bei einer Vorrichtung der eingangs genannten Art erfindungsgemäss dadurch gelöst, dass der Rahmen mindestens einen Vertikalhalter und mindestens einen Horizontalhalter umfasst, die den Deckel durchdringen, wobei der Deckel entsprechende Durchbrüche aufweist und in auf dem Rahmen festgesetzten Zustand durch den oder die Vertikalhalter an einer Bewegung senkrecht zu einer Öffnungsebene des Grundrahmens und durch den oder die Horizontalhalter an einer Bewegung parallel zur Öffnungsebene gehindert ist.

Auf diese weise ist es möglich, den Deckel sicher auf dem Rahmen zu halten und ihn auch wieder von dem Rahmen entfernen zu können, indem die Sperrung durch Biegung des Deckels senkrecht zur horizontalen Sperrichtung aufgehoben wird und der Deckel dann unter den Vertikalhaltern herausschiebbar ist. Diese Abschirmvorrichtung zeichnet sich zudem durch ihren einfachen Aufbau aus und ist in der Herstellung vergleichsweise preiswert, weil häufig nur einfach ausführbare Stanzschritte erforderlich sind um den Rahmen und den Deckel mit den entsprechenden Haltern bzw. Durchbrüchen zu erzeugen.

Eine besonders wesentliche Weiterbildung der Erfindung besteht darin, dass der Deckel ohne Verformung der Vertikal- und der Horizontalhalter gehalten ist. Die am Rahmen angeformten Halter und die entsprechenden Durchbrüche sind so gearbeitet, dass eine formschlüssige Verbindung vorgesehen ist, die automatisch beim Festsetzen des Deckels entsteht ohne dass verformungsprozesse eine Rolle spielen würden.

In weiterer zweckmässiger Ausgestaltung der Erfindung können die Vertikalhalter als Haken, vorzugsweise als L-förmiger Haken, ausgestaltet sein. Der Deckel ist dann durch eine Bewegung auf dem Rahmen in der Öffnungsebene des Rahmens leicht unter die Haken führbar, wodurch sich dann eine Sperrung in vertikaler Richtung ergibt. Um das Einführen des Deckels unter die Haken zu erleichtern, kann es ergänzend vorgesehen sein, dass die Haken eine Einführschräge aufweisen.

Eine besonders vorteilhafte Ausgestaltung der Vertikalhalter kann es vorsehen, die Vertikalhalter als Rastlager auszuführen, die mit den entsprechenden Durchbrüchen im Deckel eine Rastverbindung eingehen.

Eine konstruktiv besonders geschickte Lösung, die das Zusammenführen von Rahmen und Deckel sehr stark erleichtert, besteht darin, die Horizontalhalter so zu formen sind, dass der Deckel beim Aufschieben auf Führungsschrägen aus der Öffnungsebene auslenkbar und anschliessend mit seinen Durchbrüchen hinter den Rastlagern verschnappbar ist. Damit bleiben die Rastlager beim Ausschieben des Deckel unbeweglich stehen und sperren so nach dem Zurückschnappen des ausgelenkten Deckels (besser gesagt: des ausgelenkten Deckelbereichs) das Zurückschieben des Deckels. Dabei ist es natürlich besonders zweckmässig, wenn der Deckel aus elastisch verbiegbarem Blech besteht.

Das Kriterium der partiellen Verbiegbarkeit des Deckels lässt sich besonders gut erfüllen, wenn der Deckel siebartig gelocht ist. Dann erlaubt der Deckel auch die Hindurchleitung von heisser Luft zum Verlöten der in der Abschirmvorrichtung befindlichen Bauelemente. Eine geeignete Abschirmvorrichtung ist dann so aufgebaut, dass der Rahmen einseitig auf einer Leiterplatte festsetzbar ist. Dies bedeutet, dass die Abschirmvorrichtung (Deckel mit ausgesetzem Rahmen) SMT-bestückbar ist und verlötet werden kann. Es können jedoch auch zunächst noch sämtliche mit der Vorrichtung abzuschirmenden Bauelemente bestückt werden und anschliessend die Abschirmvorrichtung aufgesetzt und gemeinsam mit den Bauelementen verlötet werden.

Weitere vorteilhafte Ausgestaltungen der Erfindung sind den übrigen Unteransprüchen zu entnehmen.

Ausführungsbeispiele der Erfindung werden nachfolgend anhand einer Zeichnung näher erläutert. Dabei zeigen:
- Figur 1: einen Ausschnitt aus einer perspektivischen Ansicht einer Abschirmkammer, umfassend einen Grundrahmen und einen Deckel;
- Figur 2: die Abschirmkammer gemäss Figur 1 mit auf dem Grundrahmen festgesetzten Deckel; und
- Figur 3: eine Seitenansicht der Abschirmkammer gemäss den Figuren 1 und 2 mit einer Momentaufnahme beim Aufsetzen des Deckels.

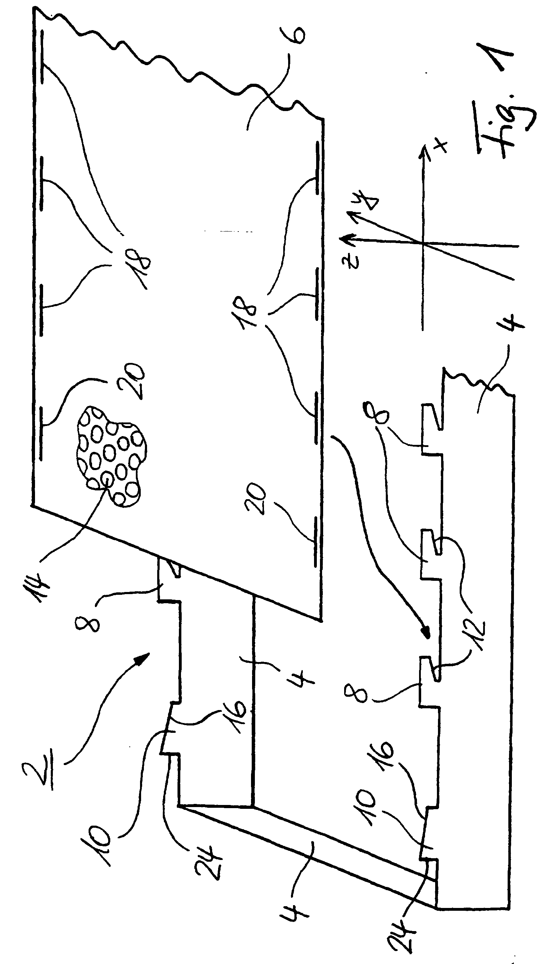

Figur 1 zeigt einen Ausschnitt aus einer perspektivischen Ansicht einer Abschirmkammer 2, die einen Grundrahmen 4 und einen auf dem Grundrahmen 4 lösbar festsetzbaren Deckel 6 umfasst. Der Grundrahmen 4 wird in hier nicht weiter dargestellter Weise auf einer Leiterplatte durch Löten befestigt. Bei diesem Lötvorgang kann der Deckel 6 bereits auf dem Grundrahmen 4 aufgesetzt sein, wodurch die Abschirmkammer 2 ebenso wie hier nicht weiter dargestellte Bauelemente, die mittels der Abschirmkammer 2 abgeschirmt werden sollen, SMT-bestückbar ist. Der Deckel 6 weist zudem ein siebähnliches nur ausschnitthaft dargestelltes Lochmuster 14 auf, welches einerseits das gemeinsame Verlöten des Grundrahmens 4 und der Bauelemente erlaubt und andererseits zu einer verbesserten Biegbarkeit des Deckels 6 beitragen kann.

Zum Festsetzen des Deckels 6 auf dem Grundrahmen 4 weist der Grundrahmen 4 Vertikalhalter 8 und Horizontalhalter 10 auf. Dabei haben die Vertikalhalter 8 eine L-Form und verfügen zudem über eine Einführungsschräge 12, die ein Einführen des Deckels 6 unter die Vertikalhalter 8 erleichtert. Die Vertikalhalter 10 weisen eine Führungsschräge 16 auf, die ein Auslenken des Deckels 6 aus einer Öffnungsebene des Grundrahmens 4 heraus beim Aufsetzen des Deckels 6 auf den Grundrahmen 4 unterstützen.

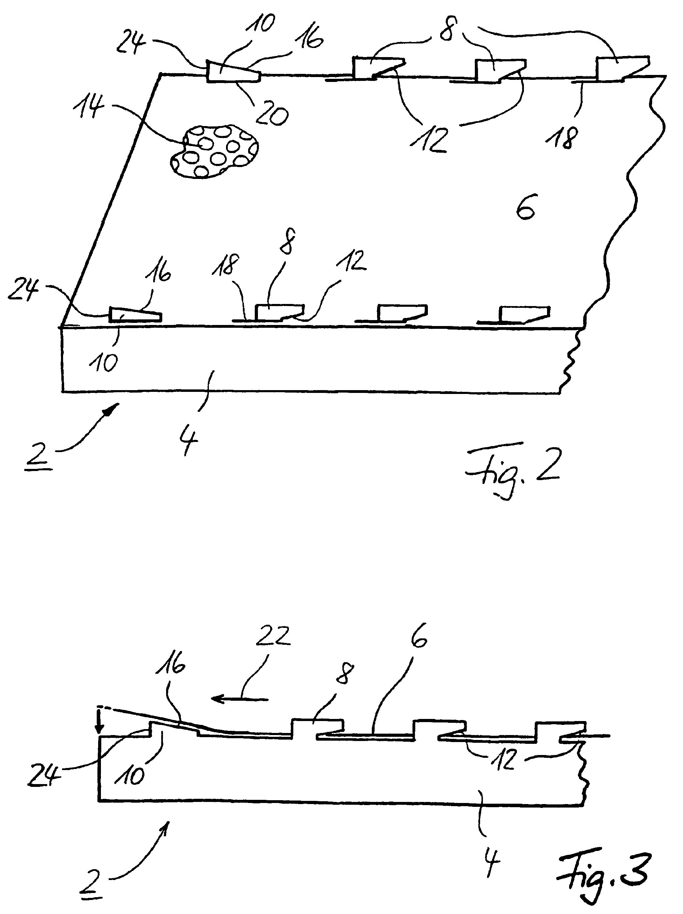

Zu diesen Vertikalhaltern 8 und Horizontalhaltern 10 korrespondierend weist der Deckel 6 schlitzförmige Durchbrüche 18,20 auf. Beim Aufsetzen des Deckels 6 auf dem Grundrahmen 4 durchdringen die Vertikalhalter 8 den Deckel 6 an seinen Durchbrüchen 18, wobei sich der Deckel 6 im Bereich der Horizontalhalter 10 zunächst aufwölbt, weil die Position der Durchbrüche 20 noch nicht mit der Position der Horizontalhalter 10 übereinstimmt. Diese Situation ist sehr anschaulich aus der in Figur 3 dargestellten Seitenansicht ersichtlich.

Mit dem weiteren Aufschieben des Deckels 6 in Richtung eines Pfeils 22 werden mit dem Anschlagen der Durchbrüche 18 an den Vertikalhaltern 8 auch die Durchbrüche 20 mit den Horizontalhaltern 10 zur Deckung gebracht. Der aus der Öffnungsebene des Grundrahmens 4 durch elastische Biegung ausgelenkte Deckel 6, d.h. sein im Einflussbereich des Horizontalhalters 10 stehender Bereich, schnappt zu diesem Zeitpunkt in die Öffnungsebene des Grundrahmens 4 zurück, wodurch der Deckel 6 nun mehr auf dem Grundrahmen 4 festgesetzt ist. Eine in z-Richtung verlaufende Kante 24 des Horizontalhalters 10 dient dabei als Rastlager, an dem die Durchbrüche 20 nun mehr anliegen. Diese Situation ist sehr anschaulich der in Figur 2 gezeigten perspektivischen Darstellung entnehmbar.

Figur 2 zeigt deutlich, dass der Deckel 6 nun nicht mehr oder nur noch in äusserst geringer und daher tolerierbarer Weise bewegbar ist. Durch die Vertikalhalter 8 wird der Deckel 6 an einer Bewegung senkrecht (z-Achse gemäss Koordinatenkreuz in Figur 1) zur Öffnungsebene (xy-Ebene gemäss Koordinatenkreuz in Figur 1) des Grundrahmens 4 gehindert. Durch die Horizontalhalter 10 wird der Deckel 6 entsprechend an einer Bewegung parallel (x-Achse gemäss Koordinatenkreuz in Figur 1) zur Öffnungsebene des Grundrahmens 4 gehindert.

Nur ein Anheben des Deckelbereichs im Einzugsbereich der Horizontalhalter 10 über dieselben hinaus erlaubt ein Zurückschieben des Deckel 6 und damit die Entfernung desselben vom Grundrahmen 4. Die Bauelemente sind dann wieder zugänglich.

### Liste der verwendeten Bezugszeichen

- 2: Abschirmkammer
- 4: Grundrahmen
- 6: Deckel
- 8: Vertikalhalter
- 10: Horizontalhalter
- 12: Einführschräge
- 14: Lochraster
- 16: Führungsschräge
- 18: Durchbrüche
- 20: Durchbrüche
- 22: Pfeil
- 24: Kante

## Patentansprüche

1. Vorrichtung (2) zum Abschirmen von elektrotechnischen Bauelementen mit einem Rahmen (4) und mit mindestens einem Deckel (6), der auf dem Rahmen (4) festsetzbar ist,
**dadurch gekennzeichnet, dass**
der Rahmen (4) mindestens einen Vertikalhalter (8) und mindestens einen Horizontalhalter (10) umfasst, die den Deckel (6) durchdringen, wobei der Deckel (6) entsprechende Durchbrüche (18, 20) aufweist und in auf dem Rahmen (4) festgesetzten Zustand durch den oder die Vertikalhalter (8) an einer Bewegung senkrecht zu einer Öffnungsebene (xy-Ebene) des Rahmens (4) und durch den oder die Horizontalhalter (10) an einer Bewegung parallel zur Öffnungsebene (xy-Ebene) gehindert ist.

2. Vorrichtung (2) nach Anspruch 1,
**dadurch gekennzeichnet, dass**
der Deckel (6) ohne Verformung der Vertikal- und der Horizontalhalter (8 bzw. 10) gehalten ist.

3. Vorrichtung (2) nach Anspruch 1 oder 2,
**dadurch gekennzeichnet, dass**
die Vertikalhalter (8) als Haken, vorzugsweise als L-förmiger Haken, ausgestaltet sind und der Deckel (6) durch eine Bewegung auf dem Rahmen (4) in der Öffnungsebene (xy-Ebene) des Rahmens (4) unter die Haken führbar ist.

4. Vorrichtung (2) nach Anspruch 3,
**dadurch gekennzeichnet, dass**
die Haken eine Einführschräge (12) aufweisen.

5. Vorrichtung (2) nach einem der Ansprüche 1 bis 4,
**dadurch gekennzeichnet, dass**
die Horizontalhalter (10) ein Rastlager (24) aufweisen, welches mit den entsprechenden Durchbrüchen (20) im Deckel (6) eine Rastverbindung eingeht.

6. Vorrichtung (2) nach Anspruch 4 oder 5,
**dadurch gekennzeichnet, dass**
die Horizontalhalter (10) so geformt sind, dass der Deckel (6) beim Aufschieben auf Führungsschrägen (16) aus der Öffnungsebene (xy-Ebene) auslenkbar und anschliessend mit seinen Durchbrüchen (20) hinter den Rastlagern (24) verschnappbar ist.

7. Vorrichtung (2) nach einem der Ansprüche 1 bis 6,
**dadurch gekennzeichnet, dass**
der Deckel (6) aus elastisch verbiegbarem Blech besteht.

8. Vorrichtung (2) nach einem der Ansprüche 1 bis 7,
**dadurch gekennzeichnet, dass**
der Deckel (6) ein siebartiges Lochraster (14) aufweist.

9. Vorrichtung (2) nach einem der Ansprüche 1 bis 8,
**dadurch gekennzeichnet, dass**
der Rahmen (4) einseitig auf einer Leiterplatte festsetzbar ist.

## Claims

1. Device (2) for shielding electrotechnical components having a frame (4) and having at least one lid (6) which can be secured on the frame (4),
**characterised in that**
the frame (4) comprises at least one vertical holder (8) and at least one horizontal holder (10) which penetrate the lid (6), with the lid (6) having corresponding cutouts (18, 20) and in a state in which it is fixed to the frame (4) is prevented from moving vertically with respect to an opening plane (xy plane) of the frame (4) by the vertical holder(s) (8) and prevented from moving in parallel with the opening plane (xy plane) by the horizontal holder(s) (10).

2. Device (2) according to claim 1,
**characterised in that**
the lid (6) is held without deformation of the vertical and horizontal holders (8 and 10 respectively).

3. Device (2) according to claim 1 or 2,
**characterised in that**
the vertical holders (8) are embodied as hooks, preferably as L-shaped hooks, and the lid (6) can be guided under the hooks by means of a movement on the frame (4) in the opening plane (xy plane) of the frame (4).

4. Device (2) according to claim 3,
**characterised in that**
the hooks have an insertion bevel (12).

5. Device (2) according to one of the claims 1 to 4,
**characterised in that**
the horizontal holders (10) have a latching bearing (24) which engages in a latch-and-lock connection with the corresponding cutouts (20) in the lid (6).

6. Device (2) according to claim 4 or 5,
**characterised in that**
the horizontal holders (10) are shaped such that the lid (6), when being pushed up onto guide bevels (16), can be deflected from the opening plane (xy plane) and subsequently snapped into place by means of its cutouts (20) behind the latching bearings (24).

7. Device (2) according to one of the claims 1 to 6,
**characterised in that**
the lid (6) is made of elastically bendable metal plate.

8. Device (2) according to one of the claims 1 to 7,
**characterised in that**
the lid (6) has a sieve-like hole pattern (14).

9. Device (2) according to one of the claims 1 to 8,
**characterised in that**
the frame (4) can be fixed on one side on a printed circuit board.

## Revendications

1. Dispositif (2) de blindage de composants électrotechniques comprenant un cadre (4) et au moins un couvercle (6) qui peut être posé de manière fixe sur le cadre (4),
**caractérisé en ce que**
le cadre (4) comprend au moins un élément (8) de maintien vertical et au moins un élément (10) de maintien horizontal qui traverse le couvercle (6), le couvercle (6) ayant des traversées (18, 20) correspondantes et dans l'état posé sur le cadre (4), il est fait obstacle, par le ou les éléments (8) de maintien vertical, à un mouvement perpendiculaire au plan d'ouverture (plan xy) du cadre (4), et, par le ou les éléments (10) de maintien horizontal, à un mouvement parallèlement au plan d'ouverture (plan xy).

2. Dispositif (2) suivant la revendication 1,
**caractérisé en ce que** le couvercle (6) est maintenu sans déformation des éléments (8 et 10) de maintien vertical et horizontal.

3. Dispositif (2) suivant la revendication 1 ou 2,
**caractérisé en ce que** les éléments (8) de maintien vertical sont constitués sous la forme de crochets, de préférence de crochets en forme de L, et le couvercle (6) peut passer, par un déplacement sur le cadre (4) dans le plan d'ouverture (plan xy) du cadre (4), sous les crochets.

4. Dispositif (2) suivant la revendication 3,
**caractérisé en ce que** les crochets ont un biseau (12) d'introduction.

5. Dispositif (2) suivant l'une des revendications 1 à 4,
**caractérisé en ce que** les éléments (10) de maintien horizontal ont un palier (24) d'encliquetage qui entre en liaison d'encliquetage avec les traversées (20) correspondantes du couvercle (6).

6. Dispositif (2) suivant la revendication 4 ou 5,
**caractérisé en ce que** les éléments (10) de maintien horizontal sont conformés de manière à ce que le couvercle (6) puisse être dévié hors du plan d'ouverture (plan xy) lors du déplacement sur des rampes (16) de guidage et puisse être ensuite encliqueté par ses traversées (20) derrière les paliers (24) d'encliquetage.

7. Dispositif (2) suivant l'une des revendications 1 à 6,
**caractérisé en ce que** le couvercle (6) est en une tôle pouvant se courber élastiquement.

8. Dispositif (2) suivant l'une des revendications 1 à 7,
**caractérisé en ce que** le couvercle (6) comporte une trame (14) perforée à la manière d'un tamis.

9. Dispositif .(2) suivant l'une des revendications 1 à 8,
**caractérisé en ce que** le cadre (4) peut être fixé d'un côté sur une plaquette à circuit imprimé.
